# EUROPEAN PATENT SPECIFICATION

(11) **EP 2 284 863 B1**
(45) Date of publication and mention of the grant of the patent: **04.04.2012**
(21) Application number: 09167663.5
(22) Date of filing: 11.08.2009
(51) Int. Cl.: H01L 21/00, H01L 21/68, H05K 13/04

(54) **Method and apparatus for inspecting a chip prior to bonding**
Verfahren und Vorrichtung zur Prüfung eines Chips vor dem Bonden
Procédé et appareil d'inspection d'une puce avant la liaison

(43) Date of publication of application: 16.02.2011
(73) Proprietor: Kulicke & Soffa Die Bonding GmbH, 8572 Berg TG (CH)
(72) Inventor: Schuster, Johannes, 78462 Konstanz (DE)
(74) Representative: Körner, Thomas Ottmar

(56) References cited:
- EP-A- 1 189 496
- WO-A-2005/013354
- WO-A-2006/038610

## Description

### Field of the Invention

The present invention pertains to the field of automation technology. It relates to an apparatus and a method for handling chips, in particular semiconductor dies, in accordance with the preamble of the independent patent claims.

### Background of the Invention

One of the biggest challenges in semiconductor packaging is picking, handling and processing of very thin semiconductor chips. The semiconductor chips are generally provided on a carrier tape, which generally contains a whole semiconductor wafer that has been cut into small chips, a process frequently referred to as dicing. The semiconductor chips are thus commonly referred to as dies. The carrier tape is often the same tape that supported the wafer during dicing, often referred to as dicing tape. Die thicknesses of down to 25µm are common today, and there is an ongoing trend to decrease thicknesses even further.

Die bonders pick a single die from the carrier tape and place and subsequently attach the picked die onto a substrate or onto another die. In most situations, the die is attached permanently, but configurations where dies are only attached temporarily also exist. Often, a temporary attachment is subsequently turned into a permanent one by an additional heating and/or pressing process. Typically, thin dies come with a wafer backside lamination (WBL) or film or flow over wire (FOW) lamination, i.e. an adhesive film which is applied to an unstructured side of the wafer or die. A process of thinning wafers, applying an adhesive film to the wafers, mounting the wafers to a carrier tape and frame, and dicing them into individual chips is usually referred to as wafer preparation. The lamination, which allows for the dies to be attached due to its adhesive properties, may be provided either between the carrier tape and the wafer, or on a surface of the wafer facing away from the carrier tape.

Picking and placing may be carried out by a single chip handling unit in the die bonder. In modern die bonders, however, a plurality of chip handling units can be present: In general, picking takes place from a so called wafer table, and is assisted by a first chip handling unit, also referred to as die ejector. The die ejector facilitates the removal of the die from the carrier tape, e.g. by pushing the die against a second chip handling unit called pick unit - from underneath the carrier tape. The pick unit subsequently picks the die from the carrier tape in a pick process and hands it over to a third chip handling unit, also referred to as place unit. The place unit places the die onto a target position, where it is attached. In some cases, at least one fourth chip handling unit - a so called transfer unit - is provided to hand the die from the pick unit to the place unit. An example is given in WO 07118511 Al which is hereby incorporated by reference in its entirety. In this manner, a die may be attached to a substrate, e.g. a leadframe, printed circuit board, multilayer board etc., or to another die, which itself may be have been attached in the same way.

The fabrication of very thin wafers and the corresponding dies is very expensive as compared to standard thickness wafers without lamination. Sawing, picking as well as handling of very thin dies have significant yield losses. Most of the yield is lost during wafer preparation, die picking, or subsequent handling, resulting in damaged dies due to typical defects as e.g. broken dies, cracked dies, chipped dies, etc. Both place and attachment processes, in comparison, are more reliable, giving rise to only negligible loss.

Known inspection methods for detecting broken, cracked or chipped dies on die bonders are performed before the pick process - which itself has limited yield - and are generally based on imaging a die surface under surface illumination, followed by image processing. These inspection techniques have limited reliability due to low crack contrast and crack width, die warpage - also referred to as potato chip effect - and due to the interference of crack signatures with other similar looking patterns on the die surface.

In particular for stacked die bond processes where two or more dies are attached onto one another, attaching of a broken die may have dramatic consequences: If a damaged die is attached onto a stack, all previously attached dies in that stack - also referred to as package - are lost. In an extreme situation, for example, a package consisting of 15 stacked dies may thus be lost by attaching a broken 16th die on top of it. Reference is likewise made to prior art documents WO 2005 013354, WO 2006 038610, and EP 1189496.

### Summary of the invention

It is thus an object of the invention to allow for an inspection after picking of a die rather than - or in addition to - one before picking of the die, e.g. on a die ejector, and thus guarantee that only undamaged dies are attached to a substrate or a previously attached die by a die bonder.

In addition, the invention shall allow for an identification of damaged dies before attach, and thus to allow for omitting to place such damaged dies onto a substrate or a stack of previously attached dies. Ideally, inspection of the die should be possible immediately before it is placed and subsequently attached to the substrate or to an already attached die.

It is further an object of the invention to maximize a signal-to-noise ratio and a success rate of a crack detection.

It is yet another an object of the invention to allow for additional inspections, in particular, an inspection of die pattern or structure integrity, a detection of a chip ID, an exact alignment prior to transfer, etc., to be carried out efficiently.

The above objects are achieved by a chip handling tool and a process for handling a chip according to the independent claims.

They may in particular be achieved by generating a back-illumination image of the die - also referred to as an absorption image - in which cracks, missing parts, patterns, etc. are identified as areas of substantial change of the light intensity transmitter through the die. If, for example, a visible light source is used for illumination, cracks appear as bright lines on a fully dark background of practically zero light transmission, with no intrinsic die surface patterns being visible or disturbing subsequent signal processing. A much better signal-to-noise ration can thus be achieved when compared to known inspection methods based on surface illumination.

In an exemplary embodiment of the present invention, a chip handling tool, in particular for use in a semiconductor die bonder, is presented. The chip handling tool is configured to receive a chip, in particular a semiconductor die, at a takeover location and to hand over said chip to a delivery location, and comprises a work surface configured to be brought into connection with a first surface on a first side of the chip. The chip handling tool further comprises illumination means for illuminating the chip from its first side while said first side of the chip is in connection with the work surface.

In another exemplary embodiment of the present invention, a chip handling process, in particular for a die bonding process, is presented in which a chip, in particular a semiconductor die, is received at a takeover location by a chip handling tool, and handed to a delivery location by means of said chip handling tool. At the takeover location, a work surface of the chip handling tool is brought into connection with a first surface on a first side of the chip. The chip is then illuminated from the first side while being in connection with the work surface of the chip handling tool, and light having passed through the chip is detected and analyzed for damages of the chip.

The aforementioned and further objectives, advantages and features of the invention will be detailed in the description of preferred embodiments below in combination with the drawings.

### Brief Description of the Drawings

The invention is best understood from the following detailed description when read in connection with the accompanying drawing. It is emphasized that, according to common practice, the various features of the drawing are not to scale. On the contrary, the dimensions of the various features are arbitrarily expanded or reduced for clarity. Included in the drawing are the following figures:
Fig. 1 shows a chip handling tool in accordance with an embodiment of the present invention.
Fig. 2 shows chip handling tools in accordance with an example of the present invention.
Fig. 3 shows a die bonder in accordance with an example embodiment of the present invention.
Fig. 4 shows a die ejector in accordance with an embodiment of the present invention.
Fig. 5 shows a flow diagram illustrating a chip handling process in accordance with an embodiment of the present invention.

### Detailed Description of the Invention

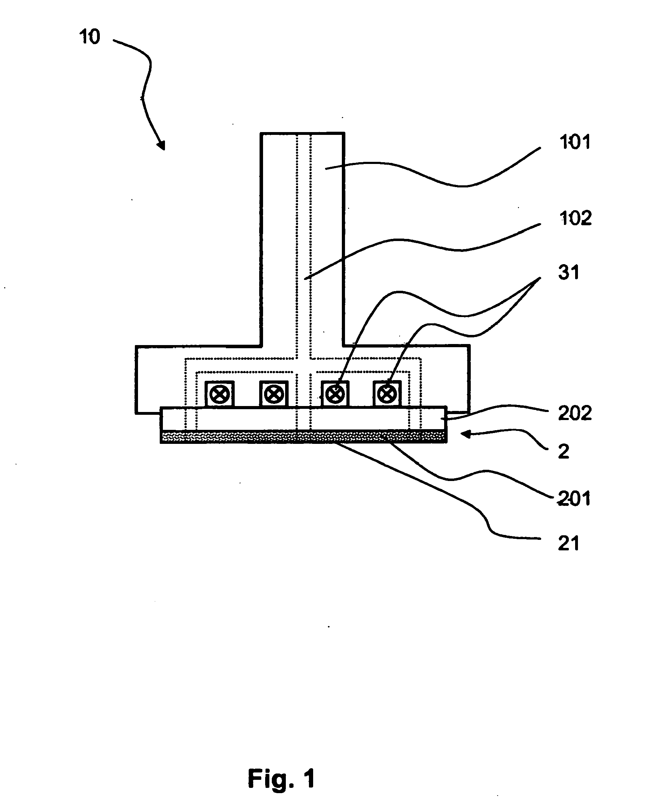

Fig. 1 shows a chip handling tool 10 according to an embodiment of the present invention. On a tool body 101 made from a rigid material, preferably metal, an at least partially transparent layer 2 is provided that comprises a surface sublayer 201 which consists of elastic matrial, e.g. silicone rubber, and has a work surface 21, which may be brought into contact with a first surface on a first side of a die to be handled by the chip handling tool 10; or vice versa. The die may or may not be provided with a WBL or FOW lamination. The tool body 101 comprises a plurality of light emitting diodes 31 that serve as an integrated light source. Alternatively, one or more light sources may be provided in or on the surface of the tool body 101. Layer 2 comprises a base layer 202 which also consists of a material that is at least partially transparent to the illumination from the light emitting diodes 31. Preferably, sublayer 201 and/or base layer 202 exhibit some scattering to provide for a more uniform illumination of dies handled by the chip handling tool 10. The first surface of the die, while in close contact with the work surface 21 of layer 2, may thus be illuminated through said work surface 21. Thin vacuum channels 102 in the chip handling tool 10 allow for a vacuum to be applied in order to temporarily fix the die to the work surface 21, and thus hold the die while it is being transported from a first location to a second location different from the first location by means of the chip handling tool 10. Other means for temporarily fixing the die to the work surface 21 may be provided. In particular, e.g. electrostatic means or an adhesive work surface 21 may be employed.

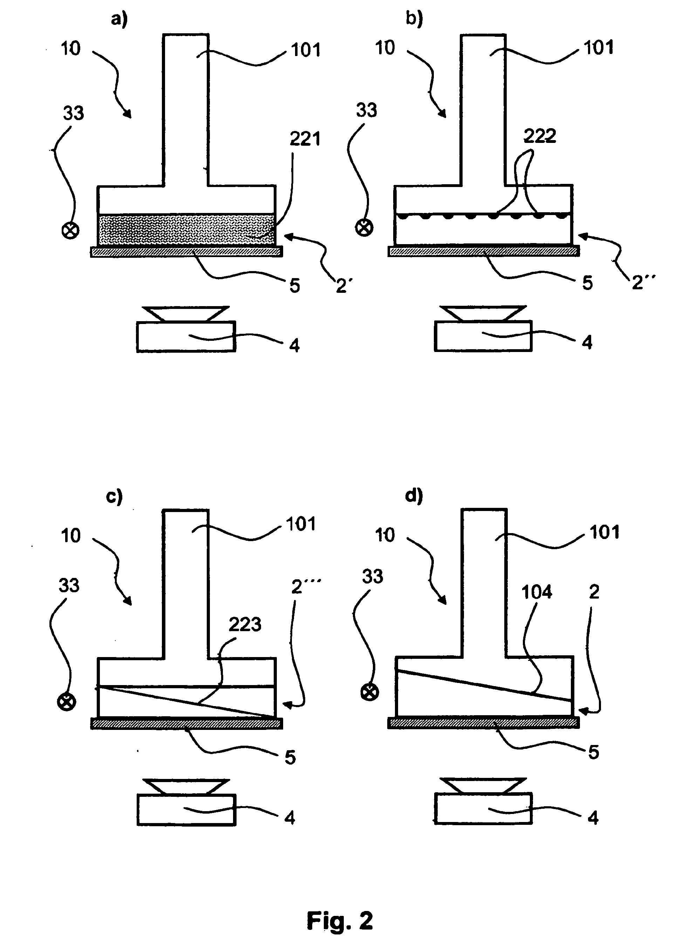

In an example of the present invention as shown in Fig. 2a-d, the chip handling tool 10 itself does not comprise any light source. However, means for redirecting light are provided so that light from an external light source 33 may be used to illuminate the die 5 held by the work surface 21 of the chip handling tool 10. This may be achieved by forming the at least partially transparent layer 2 of a material that scatters, diffracts or reflects light from light source 33, e.g. due to scattering centers 221, 222 provided within the volume of layer 2' as shown in Fig. 2a, on a back surface and/or a front surface of layer 2", or on a front surface of the tool body 101 as shown in Fig 2b; or a combination thereof. It may also be achieved by providing an at least partially reflective zone 223 within layer 2"' as shown in Fig. 2c, or by providing the tool body 101 with a reflective surface 104 that forms an angle with the work surface 21 as shown in Fig. 2d, or any combination of one or more of the different variants shown. Preferably, layers 2', 2", 2"' are made of or comprise regions made of resilient material. Combinations of the second and first embodiments are also possible.

If a light sensitive element 4 is provided at a location opposite a second surface of the die 5, defects of die 5 may be detected due to the fact that a broken, cracked, chipped or similarly damaged die 5 will allow for a significantly bigger amount of light to reach the light sensitive element 4 than an undamaged die 5. Preferably, an image acquisition tool, e.g. CCD element or CMOS light sensor array, is used as light sensitive element 4. Image processing methods may then be employed to discriminate between undamaged and damaged dies. For example, image processing algorithms may be used to detect bright spots in areas that are expected to be dark for undamaged dies. However, when adequately calibrated, one or several light detectors, e.g. an area photo detector measuring peak or total transmission, may also suffice for the purpose of detecting die damage. A threshold operation which may either be implemented in the photo detector itself, or in a control system to which the detector is connected may then perform discrimination between undamaged and damaged dies. This may allow for a much faster, simpler and potentially cheaper discrimination procedure, as no image processing and thus no image processing software is required.

Preferably the chip handling tool 10 is configured to be moved in at least two of the six degrees of freedom represented by linear coordinates *x*, *y*, *z*, and angular coordinates θ*ₓ*, θ*y*, θ*_{z}* by means of an associated chip handling unit. This allows for the chip handling tool 10 to actively grab a die 5 to be received. Alternatively, the chip handling tool 10 may also have one degree of freedom only. In this case, in general the die 5 needs to be handed to the chip handling tool 10. In particular, the chip handling tool 10 may be formed as a rotating disc or a conveyor belt, so that a plurality of dies 5 may simultaneously be in contact with the work surface 21, and be transported from the first location to the second location in parallel.

In all the examples described above, contactless die handling may alternatively be used to advantage. Rather than by bringing the work surface 21 and the first surface of the die 5 into contact as described above, the die may be held in position with a small gap between its first surface and the work surface 21 as a consequence of an equilibrium of attractive and repulsive forces acting onto the die 5. An example of how this may be achieved for wafers is given in US 5 080 549, which is hereby included by reference in its entirety.

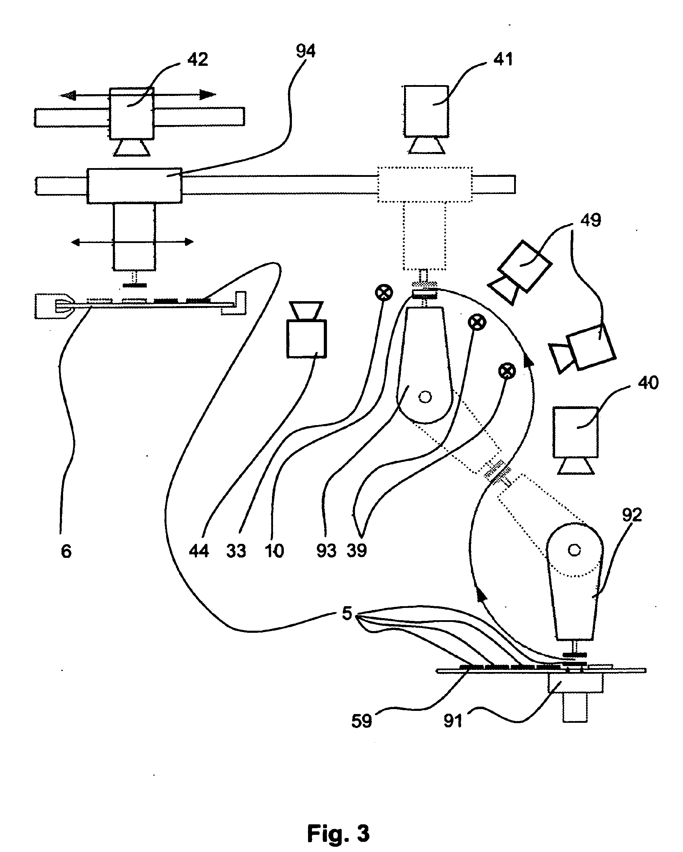

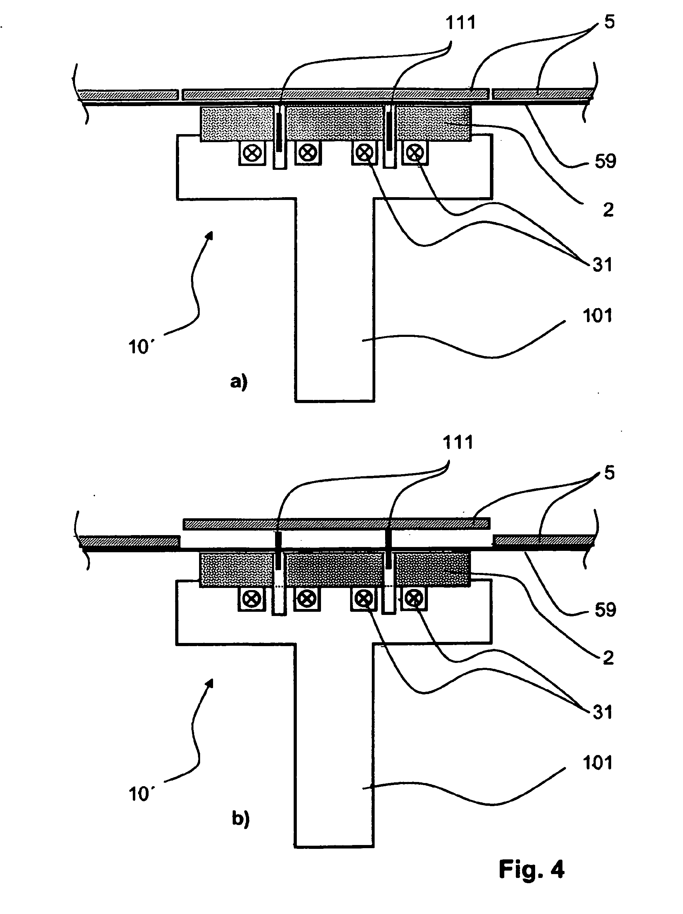

Fig. 3 shows a schematic of an example of a die 5 bonder according to the present invention. The die bonder comprises a plurality of chip handling units: A first chip handling unit 91, a so called die ejector, ejects a die 5, which may be laminated with a WBL or FOW lamination, from a carrier tape. After the die 5 has been ejected, it is taken over by a second chip handling unit 92 also referred to as pick unit. The pick unit is capable of rotating around a first axis, and configured to hand the die 5 over to a third chip handling unit 93. Said third chip handling unit 93, also referred to as transfer unit, is capable of rotating about a second axis, and may thus hand the die 5 to a fourth chip handling unit 94 also referred to as place unit, which in turn will take the die 5 over from the transfer unit 93 and transport it to and place it onto a target position on a substrate 6. The transfer unit 93 comprises a chip handling tool 10 according to the present invention as described above by means of examples. When the transfer unit is at a delivery location as represented by a solid line in Fig. 4, and the die 5 is illuminated through the illumination means provided in the chip handling tool 10, light from the integrated light source of the chip handling tool 10 or an external light source 33 having passed through the die 5 may be detected by a transfer camera 41. The die bonder further comprises a control system not shown in Fig. 3 to control the movements of the various chip handling units etc.

In an image acquired by the transfer camera 41 when the die 5 is illuminated by the illumination means, cracks, broken or chipped off areas and similar damages appear as bright spots, whereas integrity areas appear as dark areas. In order to achieve sufficiently good contrast, an appropriate illumination wavelength has to be chosen that is sufficiently well absorbed by the semiconductor material of the die 5. Visible light illumination is generally appropriate. Based on a discrimination between damaged and undamaged dies as described above, exception handling controls may then allow for avoiding attaching of broken dies, and for removing them from the transfer unit 93.

In a preferred example of the present invention, the die 5 may also be illuminated by non-visible light, in particular light in the infrared wavelength range in which a semiconductor material is at least partially transparent. Wavelengths between 1.2 and 1.7 µm are particularly well suited, especially for silicon dies as they allow for inspections of an integrated circuit pattern of the die 5. In addition, simple cameras that work without cooling or residual light amplification are readily available for these wavelengths. Dies 5 that are faulty, e.g. due to corrupted circuit patterns etc. may thus be detected and also be regarded and treated as damaged. In addition, die ID markings may be visualized. An illumination allowing for illumination with different wavelengths may also be employed to advantage.

Heating the die 5 is often necessary for permanent attachment to a substrate or another die. Heating elements, in particular resistive heating elements, may be provided in the chip handling tool 10. The at least partially transparent layer 2, 2', 2", 2"', or at least sublayer 201, preferably should be made from material that shows both sufficient heat resistance, and preferably good heat conductivity. To avoid damage to the die 5 due to electrostatic discharge, the at least partially transparent layer 2, 2', 2", 2"', or at least sublayer 201 should preferably also exhibit good electrical conductivity. Alternatively, a thin layer of a conducting transparent material, e.g. indium tin oxide (ITO) may be provided on the work surface 21. Such a thin layer may also be used for heating.

Preferably, transfer camera 41 may also be used for other inspection or measurement purposes in the die bonder, in particular to determine an exact transfer position of the die 5 held by the transfer unit 91. Exact knowledge of the transfer position may be necessary for the place unit 94 to take the die 5 over and accurately place it onto a target position on the substrate 6 determined by a place camera 42. For this purpose referred to as die alignment, a transfer position lamp may be provided to illuminate the die 5 while being held by the transfer unit 93 at the transfer position. Preferably, the transfer position lamp is dimmed or turned off when the die 5 is examined for damages. Alternatively, when non-visible light in the infrared wavelength range is used, a single light source may be deployed for both detection of die defects and/or imaging of die alignment patterns on the die surface.

In the inventive die bonder as discussed above, the chip handling tool ID according to the invention may also be used as part of other chip handling units 91, 92, 93, 94 either instead of or in combination with the chip handling tool 10 of the transfer unit 93. In this respect, it is particularly advantageous to provide the chip handling tool 10 according to the invention as part of the place unit 94. This will allow detecting all die damage that may be caused prior to attaching the die 5 to the substrate, in particular damage due to a handing over of the die 5 to the place unit 94. Excellent placement accuracy may then be achieved when a placement camera 44 is used as light sensitive element and to determine an exact position and/or rotation of the die 5 handled by the place unit.

It may also be of particular interest to use a chip handling tool 10' according to the invention as part of the die ejector unit 91. In this case, removing damaged dies from the carrier tape 59 can be avoided upfront, thus leaving defective parts on the carrier tape and avoiding any handling of those dies on the die bonder. The latter implementation results in higher throughput of the die bonder and reduces operator intervention. Fig. 4a shows an example of a chip handling tool 10' that comprises ejection pins 111 that may protrude from the chip handling tool 10' as shown in Fig. 4b to eject a die from the carrier tape 59. However, other means to eject or remove the die from the carrier tape may be included in the tool 10', e.g. as described in WO 2005/117072 Al. Light having passed through the die 5 may for example be analyzed by a pick camera 40.

In the die bonders discussed so far, an orientation in which the die is supported by the carrier tape is identical to the orientation in which the die 5 is attached to the substrate 6. In certain applications frequently referred to as flip chip applications, however, the die 5 is to be inserted prior to attachment to the substrate 6. In the die bonder described above, this may be achieved by providing a flip unit that receives the die 5 from the transfer unit 93 and hands it over to the place unit 94. Alternatively, it may be achieved by leaving away the transfer unit 93 so that the pick unit 92 may hand the die 5 over directly to the place unit 94. Of course in this latter case, the inventive chip handling tool 10 has to be provided at a chip handling unit other than the transfer unit, in particular at the pick unit 92 or the place unit 94. Since for flip chip applications, the die 5 is generally attached with a structured surface facing the substrate 6 or an already attached die, placement accuracy is extremely important. Therefore, placement camera 44 is generally provided to allow for acquisition of an image of the structured surface of the die while the die is being held by the place tool 94, and may be used to discriminate between damaged and undamaged dies.

In an alternative example of a die bonder according the present invention, one or more light sensitive elements 49, in particular one or more line scan cameras, may be provided along a path of movement of the chip handling tool 10 in such a way that light by the illumination means having passed through the die reaches the light sensitive element or elements 49 as the chip handling tool 10 with the die passes by. Similarly, if a chip handling tool 10 as shown in Fig. 2 is deployed, one or more external light sources 39 may also be provided along the path in a vicinity of the light sensitive elements 49, so that the first side of the die is illuminated when the chip handling tool 10 passes by.

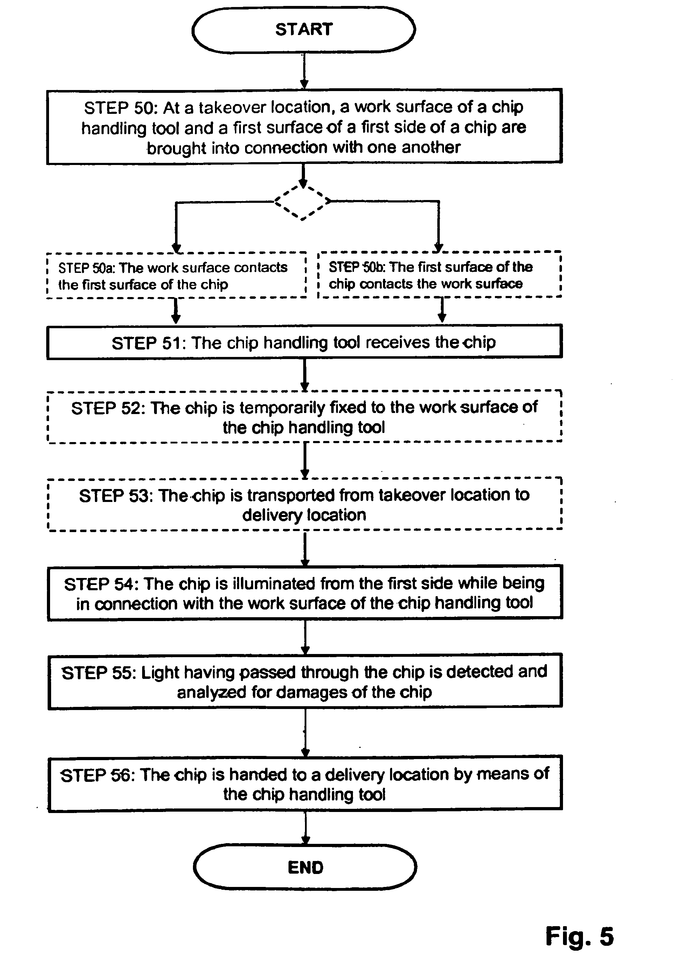

Fig. 5 is a flow diagram in accordance with certain exemplary embodiments of the present invention. As is understood by those skilled in the art, certain steps included in the flow diagram may be omitted; certain additional steps may be added, and the order of the steps may be altered from the order illustrated.

Although the invention is illustrated and described herein with reference to specific embodiments, the invention is not intended to be limited to the details shown. Rather, various modifications may be made in the details within the scope and range of equivalents of the claims and without departing from the invention.

In particular, although the invention was described above with respect to semiconductor dies, it may be used for any kind of chip, including any essentially a flat slab of material or materials that is picked from any kind of supply carrier, in particular a tape or belt, and placed onto a target location, in particular on a chip, substrate, tape, belt or a storage means.

## Claims

1. A chip handling tool (10), in particular for use in a semiconductor die bonder, said chip handling tool (10) being configured to receive a chip (5), in particular a semiconductor die, at a takeover location and to hand over said chip (5) to a delivery location, said chip handling tool (10) comprising
a) a work surface (21) configured to be brought into connection with a first surface on a first side of the chip (5), **characterized in that** the chip handling tool (10) further comprises
b) illumination means (31, 104, 221, 222, 223) for illuminating the chip (5) from its first side while the said first side of the chip (5) is in connection with the work surface (21).

2. The chip handling tool (10) according to claim 1, further comprising means (102) for temporarily fixing the chip (5) to the work surface (21).

3. A chip handling tool (10) according to one of the previous claims, wherein the tool (10) comprises an at least partially transparent region (2, 2', 2", 2"', 201, 202), and wherein the work surface (21) is formed on said at least partially transparent region (2, 2', 2", 2"', 201).

4. The chip handling tool (10) according to claim 3, wherein means for redirecting light (104, 221, 222, 223) onto the work surface (21), in particular by means of scattering, diffraction or reflection, are provided in the at least partially transparent region (2, 2', 2", 2"', 201, 202), or at a back surface thereof.

5. The chip handling tool (10) according to claim 3, wherein the at least partially transparent region (2, 2', 2", 2"', 201, 202) comprises a resilient material subregion (2, 2', 2", 2"', 201, 202), in particular a rubber layer (201)

6. The chip handling tool (10) according to claim 5, wherein the work surface (21) is formed on the resilient material subregion (2, 2', 2", 2"', 201).

7. A chip handling tool (10) according to one of the previous claims, wherein the chip handling tool (10) comprises heating means for heating the chip (5) when in connection or proximity with the work surface (21).

8. A chip handling tool (10) according to one of the previous claims, wherein at least one light source (31) is provided in or on a rigid tool body (101) of said chip handling tool (10) to illuminate the chip (5) through the at least partially transparent region (2, 2', 2", 2"', 201, 202) and the work surface (21).

9. A chip handling process, in particular for a die bonding process, in which
a) a chip (5), in particular a semiconductor die, is received at a takeover location by a chip handling tool (10), and handed to a delivery location by means of said chip handling tool (10),
b) at the takeover location, a work surface (21) of the chip handling tool (10) is brought into connection with a first surface on a first side of the chip (5), **characterized in that**
c) the chip (5) is illuminated from the first side while being in connection with the work surface (21) of the chip handling tool (10), and that
d) light having passed through the chip (5) is detected and analyzed for damages of the chip (5).

10. The chip handling process according to claim 9, wherein in step a), the chip (5) is temporarily fixed to the work surface (21) of the chip handling tool (10) while it is being transported from the takeover location to the delivery location.

11. The chip handling process according to claim 10, wherein the light having passed through the chip (5) is detected while the chip (5) is being transported.

12. The chip handling process according to claim 9, 10 or 11, wherein in step d), an image of the chip (5) is acquired, and wherein a position/and or rotation of the chip (5) is subsequently determined from the acquired image.

13. A chip processing apparatus, in particular a semiconductor die bonder, said chip processing apparatus comprising
a) a chip handling tool (10) according to one of claims 1 to 7
b) at least one light source (33, 39) for illuminating a chip (5) in connection with the work surface (21) of the chip handling tool (10) in conjunction with the illumination means (31, 104, 221, 222, 223), and
c) a light sensitive element (4, 40, 41, 44) being configured to detect light transmitted through a chip (5) handled by the chip handling tool (10) when illuminated by the at least one light source (33, 39) in conjunction with the illumination means (31, 104, 221, 222, 223), and
d) discrimination means configured to determine whether the chip (5) is damaged based upon properties of the detected light that is transmitted through the chip (5).

14. A chip processing apparatus, in particular a semiconductor die bonder, said chip processing apparatus comprising
a) a chip handling tool (10) according to claim 8
b) a light sensitive element (4, 40, 41, 44) being configured to detect light transmitted through the chip (5) when illuminated by the at least one light source comprised by the chip handling tool (10), and
c) discrimination means configured to determine whether the chip (5) is damaged based upon properties of the detected light that is transmitted through the chip (5).

15. A chip processing apparatus according to claim 13 or 14, wherein the light sensitive element (4, 40, 41, 44) is capable of acquiring an image of the chip (5) that is in connection with the work surface (21), and wherein the discrimination means comprise image processing means capable of determining a position and/or rotation of the chip (5).

## Patentansprüche

1. Ein Chipmanipulationswerkzeug (10), insbesondere zur Verwendung in einem Halbleiter-Chipmontageautomaten, welches dazu eingerichtet ist, einen Chip (5), insbesondere einen Halbleiterchip, an einer Übernahmeposition zu empfangen und zu einer Übergabeposition zu transportieren, wobei das Chipmanipulationswerkzeug (10)
a) eine Arbeitsfläche (21) umfasst, die dazu eingerichtet ist, mit einer ersten Oberfläche auf einer ersten Seite des Chips (5) in Verbindung gebracht zu werden, **dadurch gekennzeichnet, dass** das Chipmanipulationswerkzeug (10) weiterhin
b) Beleuchtungsmittel (31, 104, 221, 222, 223) umfasst, um den Chip (5) von dessen erster Seite her zu Beleuchten, während diese sich in Verbindung mit der Arbeitsfläche (21) befindet.

2. Das Chipmanipulationswerkzeug (10) gemäss Anspruch 1, umfassend zusätzliche Mittel (102) zum vorübergehenden fixieren des Chips (5) an der Arbeitsfläche (21)

3. Das Chipmanipulationswerkzeug (10) gemäss einem der vorangehenden Ansprüche, wobei das Werkzeug (10) einen zumindest teilweise transparenten Bereich (2, 2', 2", 2"', 201, 202) umfasst, und wobei die Arbeitsfläche (21) auf diesem zumindest teilweise transparenten Bereich (2, 2', 2", 2"', 201, 202) gebildet ist.

4. Das Chipmanipulationswerkzeug (10) gemäss einem der vorangehenden Ansprüche, wobei in dem zumindest teilweise transparenten Bereich (2, 2', 2", 2"', 201, 202) oder auf einer rückwärtigen Seite desselben Mittel zum Umlenken von Licht (104, 221, 222, 223), insbesondere mittels Streuung, Beugung oder Refektion, auf die Arbeitsfläche (21) vorgesehen sind.

5. Das Chipmanipulationswerkzeug (10) gemäss einem der vorangehenden Ansprüche, wobei der zumindest teilweise transparenten Bereich (2, 2', 2", 2"', 201, 202) einen Teilbereich (2, 2', 2", 2"', 201, 202) aus elastischem Material, insbesondere eine Gummischicht (201), umfasst.

6. Das Chipmanipulationswerkzeug (10) gemäss Anspruch 1, wobei die Arbeitsfläche (21) auf dem Teilbereich (2, 2', 2", 2"', 201, 202) aus elastischem Material gebildet ist.

7. Das Chipmanipulationswerkzeug (10) gemäss einem der vorangehenden Ansprüche, wobei das Chipmanipulationswerkzeug (10) Heizelemente zum Heizen des sich in Verbindung mit oder in der Nähe der Arbeitsfläche (21) befindlichen Chips umfasst.

8. Das Chipmanipulationswerkzeug (10) gemäss einem der vorangehenden Ansprüche, wobei zumindest eine Lichtquelle (31) in oder auf einem starren Werkzeugkörper (101) des besagten Chipmanipulationswerkzeugs (10) vorgesehen ist, um den Chip durch den zumindest teilweise transparenten Bereich (2, 2', 2", 2"', 201, 202) und die Arbeitsfläche (21) hindurch zu beleuchten.

9. Ein Chipmanipulationsverfahren, insbesondere für einen Chipmontagevorgang, bei welchem
a) ein Chip (5), insbesondere einen Halbleiterchip, an einer Übernahmeposition von einem Chipmanipulationswerkzeug (10) empfangen und mittels des Chipmanipulationswerkzeugs (10) zu einer Übergabeposition transportiert wird
b) an der Übernahmeposition eine Arbeitsfläche (21) des Chipmanipulationswerkzeugs (10) mit einer ersten Oberfläche auf einer ersten Seite des Chips (5) in Verbindung gebracht wird, **dadurch gekennzeichnet, dass**,
c) der Chip (5) von dessen erster Seite her beleuchtet wird, während eine Verbindung mit der Arbeitsfläche (21) des Chipmanipulationswerkzeugs (10) besteht, und dass
d) Licht, welches den Chip (5) passiert hat, detektiert und auf Schäden des Chips (5) analysiert wird.

10. Das Chipmanipulationsverfahren gemäss Anspruch 9, wobei der Chip (5) in Schritt a) vorübergehend an der Arbeitsfläche (21) des Chipmanipulationswerkzeugs (10) fixiert wird, während er von der Übernahmeposition zu der Übergabeposition transportiert wird.

11. Das Chipmanipulationsverfahren gemäss Anspruch 9, wobei Licht, welches den Chip (5) passiert hat, detektiert wird während der Chip (5) transportiert wird.

12. Das Chipmanipulationsverfahren gemäss Anspruch 9, 10 oder 11, wobei im Schritt d) ein Bild des Chips (5) erfasst wird, und wobei anschliessend eine Position und/oder eine Drehung des Chips (5) aus dem Bild bestimmt wird.

13. Eine Chipbearbeitungsvorrichtung, insbesondere ein Halbleiter-Chipmontageautomat, umfassend
a) ein Chipmanipulationswerkzeug (10) gemäss einem der Ansprüche 1 bis 7
b) mindestens eine Lichtquelle (33, 39) zum Beleuchten eines mit der Arbeitsfläche (21) des Chipmanipulationswerkzeugs (10) in Verbindung befindlichen Chips (5) in Zusammenwirkung mit den Beleuchtungsmitteln (31, 104, 221, 222, 223), und
c) ein lichtempfindliches Element (4, 40, 41, 44), welches eingerichtet ist, Licht, welches einen vom Chipmanipulationswerkzeugs (10) gehaltenen und von der mindestens eine Lichtquelle (33, 39) in Zusammenwirkung mit den Beleuchtungsmitteln (31, 104, 221, 222, 223) beleuchteten Chip (5) passiert hat, zu detektieren, und
d) Unterscheidungsmittel, die konfiguriert sind, anhand von Eigenschaften des detektierten Lichts, welches den Chip (5) passiert hat, festzustellen, ob der Chip (5) beschädigt ist.

14. Eine Chipbearbeitungsvorrichtung, insbesondere ein Halbleiter-Chipmontageautomat, umfassend
a) ein Chipmanipulationswerkzeug (10) gemäss Anspruch 8,
b) ein lichtempfindliches Element (4, 40, 41, 44), welches eingerichtet ist, Licht, welches den von der mindestens einen vom Chipmanipulationswerkzeug (10) umfassten Lichtquelle beleuchteten Chip (5) passiert hat, zu detektieren, und
c) Unterscheidungsmittel, die konfiguriert sind, anhand von Eigenschaften des detektierten Lichts, welches den Chip (5) passiert hat, festzustellen, ob der Chip (5) beschädigt ist.

15. Eine Chipbearbeitungsvorrichtung gemäss Anspruch 13 oder 14, wobei das lichtempfindliches Element (4, 40, 41, 44) in der Lage ist, ein Bild des Chips (5), der sich mit der Arbeitsfläche (21) des Chipmanipulationswerkzeugs (10) in Verbindung befindet, zu erfassen, und wobei die Unterscheidungsmittel Bildverarbeitungsmittel umfassen, die in der Lage sind, eine Position und/oder eine Drehung des Chips (5) zu bestimmen.

## Revendications

1. Outil (10) de manipulation de microplaquettes, en particulier destiné à être utilisé dans une microsoudeuse de puce à semi-conducteurs, ledit outil (10) de manipulation de microplaquettes étant configuré pour recevoir une microplaquette (5), en particulier une puce à semi-conducteurs, au niveau d'un emplacement de prise en charge et pour transférer ladite microplaquette (5) à un emplacement de distribution, ledit outil (10) de manipulation de microplaquettes comprenant :
a) une surface de travail (21) configurée pour être mise en connexion avec une première surface sur un premier côté de la microplaquette (5), **caractérisé en ce que** l'outil (10) de manipulation de microplaquettes comprend en outre:
b) des moyens d'éclairage (31, 104, 221, 222, 223) pour éclairer la microplaquette (5) depuis son premier côté pendant que ledit premier côté de la microplaquette (5) se trouve connecté à la surface de travail (21).

2. Outil (10) de manipulation de microplaquettes selon la revendication 1, comprenant en outre des moyens (102) pour fixer temporairement la microplaquette (5) sur la surface de travail (21).

3. Outil (10) de manipulation de microplaquettes selon l'une des revendications précédentes, dans lequel l'outil (10) comprend une région au moins partiellement transparente (2, 2', 2'', 2"', 201, 202), et dans lequel la surface de travail (21) est formée sur ladite région au moins partiellement transparente (2, 2', 2" , 2"' , 201).

4. Outil (10) de manipulation de microplaquettes selon la revendication 3, dans lequel des moyens pour rediriger la lumière (104, 221, 222, 223) sur la surface de travail (21), en particulier par dispersion, par diffraction ou par réflexion, sont fournis dans la région au moins partiellement transparente (2, 2', 2" , 2"' , 201, 202) ou à une surface arrière de celle-ci.

5. Outil (10) de manipulation de microplaquettes selon la revendication 3, dans lequel la région au moins partiellement transparente (2, 2', 2" , 2"', 201, 202) comprend une sous-région de matériau élastique (2, 2', 2" , 2"', 201, 202), en particulier une couche de caoutchouc (201).

6. Outil (10) de manipulation de microplaquettes selon la revendication 5, dans lequel la surface de travail (21) est formée sur la sous-région de matériau élastique (2, 2', 2", 2"', 201, 202)

7. Outil (10) de manipulation de microplaquettes selon l'une quelconque des revendications précédentes, dans lequel l'outil (10) de manipulation de microplaquettes comprend des moyens de chauffage pour chauffer la microplaquette (5) en étant en connexion ou à proximité de la surface de travail (21).

8. Outil (10) de manipulation de microplaquettes selon l'une des revendications précédentes, dans lequel au moins une source de lumière (31) est fournie dans ou sur un corps d'outil rigide (101) dudit outil (10) de manipulation de microplaquettes pour éclairer la microplaquette (5) à travers la région au moins partiellement transparente (2, 2', 2'', 2"', 201, 202) et la surface de travail (21).

9. Procédé de manipulation de microplaquettes, en particulier pour un procédé de microsoudage de puce, dans lequel :
a) une microplaquette (5), en particulier une puce à semi-conducteurs, est reçue au niveau d'un emplacement de prise en charge par un outil (10) de manipulation de microplaquettes, et transférée à un emplacement de distribution par ledit outil (10) de manipulation de microplaquettes,
b) à l'emplacement de prise en charge, une surface de travail (21) de l'outil (10) de manipulation de microplaquettes est mise en connexion avec une première surface sur un premier côté de la microplaquette(5), **caractérisé en ce que**
c) la microplaquette (5) est éclairée depuis son premier côté pendant qu'il se trouve connecté à la surface de travail (21) de l'outil (10) de manipulation de microplaquettes, et **en ce que**
d) la lumière ayant traversé la microplaquette (5) est détectée et analysée à la recherche de détériorations de la microplaquette (5).

10. Procédé de manipulation de microplaquettes selon la revendication 9, dans lequel à l'étape a), la microplaquette (5) est fixée temporairement sur la surface de travail (21) de l'outil (10) de manipulation de microplaquettes au cours de son transport de l'emplacement de prise en charge à l'emplacement de distribution.

11. Procédé de manipulation de microplaquettes selon la revendication 10, dans lequel la lumière ayant traversé la microplaquette (5) est détectée au cours du transport de la microplaquette (5).

12. Procédé de manipulation de microplaquettes selon la revendication 9, 10 ou 11, dans lequel à l'étape d), une image de la microplaquette (5) est acquise, et dans lequel une position et/ou une rotation de la microplaquette (5) est ensuite déterminée à partir de l'image acquise.

13. Appareil de traitement de microplaquettes, en particulier une microsoudeuse de puce à semi-conducteurs, ledit appareil de traitement de microplaquettes comprenant :
a) un outil (10) de manipulation de microplaquettes selon l'une des revendications 1 à 7 ;
b) au moins une source de lumière (33, 39) pour éclairer une microplaquette (5) en connexion avec la surface de travail (21) de l'outil de manipulation de microplaquette (10) en relation avec les moyens d'éclairage (31, 104, 221, 222, 223), et
c) un élément sensible à la lumière (4, 40, 41, 44) configuré pour détecter la lumière transmise à travers une microplaquette (5) manipulée par l'outil (10) de manipulation de microplaquettes lorsqu'elle est éclairée par l'au moins une source de lumière (33, 39) en relation avec les moyens d'éclairage (31, 104, 221, 222, 223), et
d) des moyens de discrimination configurés pour déterminer si la microplaquette (5) est détériorée sur la base de propriétés de la lumière détectée qui est transmise à travers la microplaquette (5).

14. Appareil de traitement de microplaquettes, en particulier une microsoudeuse de puce à semi-conducteurs, ledit appareil de traitement de microplaquettes comprenant :
a) un outil (10) de manipulation de microplaquettes selon la revendication 8 ;
b) au moins un élément sensible à la lumière (4, 40, 41, 44) configuré pour détecter la lumière transmise à travers la microplaquette (5) lorsqu'elle est éclairée par l'au moins une source de lumière comprise dans l'outil (10) de manipulation de microplaquettes, et
c) des moyens de discrimination configurés pour déterminer si la microplaquette (5) est détériorée sur la base de propriétés de la lumière détectée qui est transmise à travers la microplaquette (5).

15. Appareil de traitement de microplaquettes selon la revendication 13 ou 14, dans lequel l'élément sensible à la lumière (4, 40, 41, 44) est capable d'acquérir une image de la microplaquette (5) qui se trouve connectée à la surface de travail (21), et dans lequel les moyens de discrimination comprennent des moyens de traitement d'images capables de déterminer une position et/ou une rotation de la microplaquette (5).
